(19) Europäisches Patentamt
European Patent Office
Office européen des brevets

(11) **EP 4 575 525 B1**

(12) **EUROPÄISCHE PATENTSCHRIFT**

(45) Veröffentlichungstag und Bekanntmachung des Hinweises auf die Patenterteilung:
**13.05.2026  Patentblatt 2026/20**

(21) Anmeldenummer: **24217439.9**

(22) Anmeldetag: **04.12.2024**

(51) Internationale Patentklassifikation (IPC):
**G01R 27/18** $^{(2006.01)}$   **G01R 31/52** $^{(2020.01)}$
**G01R 27/16** $^{(2006.01)}$   **G01R 27/02** $^{(2006.01)}$

(52) Gemeinsame Patentklassifikation (CPC):
**G01R 27/16; G01R 27/18; G01R 31/52;**
G01R 27/02

(54) **MESSANORDNUNG UND MESSVERFAHREN ZUR MESSUNG EINER SCHLEIFIMPEDANZ IN EINEM UNGEERDETEN STROMVERSORGUNGSSYSTEM**

MEASURING ARRANGEMENT AND MEASURING METHOD FOR MEASURING A GROUNDING IMPEDANCE IN AN UNEARTHED POWER SUPPLY SYSTEM

DISPOSITIF DE MESURE ET PROCÉDÉ DE MESURE POUR MESURER UNE IMPÉDANCE DE BROYAGE DANS UN SYSTÈME D'ALIMENTATION ÉLECTRIQUE NON MIS À LA TERRE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität:  **20.12.2023   DE 102023136029**

(43) Veröffentlichungstag der Anmeldung:
**25.06.2025   Patentblatt 2025/26**

(73) Patentinhaber: **Bender GmbH & Co. KG**
**35305 Grünberg (DE)**

(72) Erfinder: **REITZ, Julian**
**35305 Grünberg (DE)**

(74) Vertreter: **advotec.**
**Patent- und Rechtsanwaltspartnerschaft mbB**
**Georg-Schlosser-Straße 6**
**35390 Gießen (DE)**

(56) Entgegenhaltungen:
**EP-A1- 3 832 324        EP-A2- 0 915 347**
**DE-A1- 102020 114 906**

# Beschreibung

Die Erfindung betrifft eine Messanordnung und ein Messverfahren zur Messung einer Schleifenimpedanz einer aus einem aktiven Leiter und einem Schutzleiter gebildeten Fehlerstromschleife in einem ungeerdeten Stromversorgungssystem, mit einer an einem Verbrauchspunkt angeschlossenen Messeinrichtung zur Messung einer Leiter-Erde-Spannung und zur Berechnung der Schleifenimpedanz.

Des Weiteren betrifft die Erfindung ein Isolationsüberwachungsgerät zur Bestimmung des Isolationswiderstands in einem ungeerdeten Stromversorgungssystem.

Die Schleifenimpedanz stellt den Gesamtwiderstand aller Impedanzen in der Fehlerstromschleife dar und dient zur Ermittlung des Kurzschlussstroms, der durch einen Isolationsfehler entstehen kann - beispielsweise bei dem unbeabsichtigten Kontakt eines aktiven Leiters mit dem Schutzleiter in einem elektrischen Betriebsmittel. Damit der Kurzschlussstrom die Auslösestromstärke einer Überstrom-Schutzeinrichtung erreicht, muss die Schleifenimpedanz möglichst niedrig sein.

Die Messung der Schleifenimpedanz bei erstmaligen und wiederkehrenden Prüfungen von elektrischen Anlagen ist nach DIN VDE 0100-600 (IEC 60364-6) nicht nur normativ vorgeschrieben, sondern auch aus Gründen der elektrischen Sicherheit und des Brandschutzes eine wichtige Maßnahme.

Um diese Art Messungen an Stromversorgungssystemen durchführen zu können, sind auf dem Markt spezielle Messgeräte verfügbar. Oftmals ist diese Messfunktion auch Bestandteil sogenannter Installationstester, welche weitere Normprüfungen abdecken. Dokument EP0915347 offenbart ein Verfahren zur Messung des Schleifenwiderstandes in Schutzschalter geschützten Netzen.

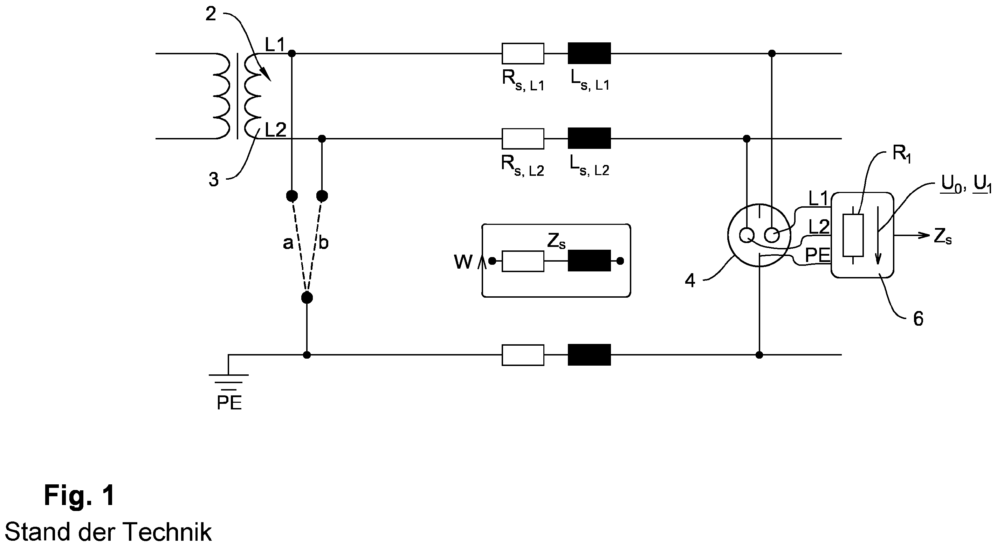

Der Stand der Technik basiert auf der Norm DIN EN 61557-3 (IEC 61557-3), welche die Anforderungen für Messgeräte zum Messen der Schleifenimpedanz (Schleifenmessgerät) beschreibt, die mit dem Verfahren der Spannungsabsenkung arbeiten. Im Rahmen dieses Verfahrens wird an der Messstelle (Verbrauchspunkt) die Leiter-Erde-Spannung im unbelasteten Fall $U_0$ (Leerlaufspannung) und im resistiv belasteten Fall $U_1$ gemessen. Im belasteten Fall senkt sich durch die vorhandene Schleifenimpedanz $Z_s$ die Leiter-Erde-Spannung geringfügig ab. Mittels der zwei Spannungswerte $U_0$, $U_1$ und der Kenntnis über den genutzten Lastwiderstand $R_1$ kann der Betrag der Schleifenimpedanz $Z_s$ berechnet werden (siehe auch Fig.1):

$$Z_s = \left| R_1 \left( \frac{U_0}{U_1} \right) - 1 \right|$$

Die Spannungswerte $U_0$, $U_1$ sind dabei kom-plexwertig, also nach Betrag und Phase, zu erfassen, um die Schleifenimpedanz Zs betragsmäßig korrekt berechnen zu können.

Sämtliche (komplexen) Widerstände in der Fehlerschleife wie beispielsweise der Widerstand des Schutzleiters PE, der Klemmstellen, der Sicherungen sowie die Impedanz einer Transformatorwicklung sind dabei von der Schleifenimpedanz Zs mit umfasst.

Während die Schleifenmessungen in geerdeten Netzen unmittelbar an dem Verbrauchspunkt, beispielsweise einer Steckdose, ohne weitere schaltungstechnische Eingriffe durchgeführt werden können, bedarf es hingegen in ungeerdeten Stromversorgungssystemen - die auch als IT-Netz (frz. Isolé Terre - IT) bezeichnet werden - bei der Prüfung besonderer technischer Maßnahmen.

Denn bei dieser Art des Stromversorgungssystems sind die aktiven Teile des IT-Netzes von dem Erdpotential getrennt - gegen Erde isoliert. Die Körper (leitfähige Gehäuse) der an das IT-Netz angeschlossenen Verbraucher sind einzeln oder gemeinsam mittels des Schutzleiters mit dem Erdpotential verbunden, somit geerdet.

Der Vorteil des ungeerdeten Stromversorgungssystems besteht darin, dass bei einem Isolationsfehler (erster Fehler), wie beispielsweise einem Erdschluss oder einem Körperschluss, die Funktion der angeschlossenen Verbraucher nicht beeinträchtigt wird, da sich wegen des im Idealfall unendlich großen Impedanzwertes zwischen einem aktiven Leiter des IT-Netzes und Erde keine geschlossene Fehlerstromschleife ausbilden kann. Durch diese inhärente Sicherheit kann somit eine kontinuierliche Stromversorgung der von dem ungeerdeten Stromversorgungssystem gespeisten Verbraucher auch dann gewährleistet werden, wenn ein erster Isolationsfehler auftritt. Insbesondere in medizinisch genutzten Bereichen findet daher diese Netzform Verwendung.

Für die Messung der Schleifenimpedanz einer aus einem aktiven Leiter und einem Schutzleiter gebildeten Fehlerstromschleife in dem ungeerdeten Stromversorgungssystem muss daher zuerst die Erdung eines aktiven Leiters in direkter Nähe des Einspeisepunktes der Netzspannung - in AC-Systemen der Netztransformator - durchgeführt werden, um in Verbindung mit einem lastseitig an dem Verbrauchspunkt angeschlossenen Messgerät eine Fehlerstromschleife herzustellen.

Die Erdung des aktiven Leiters ist allerdings in nachteiliger Weise oftmals mit zusätzlichem organisatorischem und technischem Aufwand verbunden, da die Herstellung der Erdverbindung manuell durch eine Elektrofachkraft erfolgen soll. Insbesondere in medizinischen Einrichtungen wie Krankenhäusern wäre hier eine effizientere technische Lösung wünschenswert, welche die Anzahl der wiederkehrenden Eingriffe in den Stromkreisverteiler (Verteilerschrank) reduziert.

Der vorliegenden Erfindung liegt somit die Aufgabe zugrunde, eine Messanordnung und ein Messverfahren zur Messung einer Schleifenimpedanz in einem ungeerdeten Stromversorgungssystem zu konzipieren, welche sowohl den schaltungstechnischen Aufwand als auch den zusätzlichen organisatorischen Aufwand der Messung reduzieren und insbesondere wiederkehrende, manuelle Eingriffe in die Stromkreisverteilung vermeidbar machen.

Diese Aufgabe wird mit einer Messanordnung dadurch gelöst, dass an einem Einspeisepunkt des ungeerdeten Stromversorgungssystems zwischen den aktiven Leitern und dem Schutzleiter eine gesteuerte Erdungseinrichtung angeordnet ist, welche die Erdung eines der aktiven Leiter schaltet, und dass ein unidirektionaler Kommunikationskanal zwischen einer erweiterten Messeinrichtung und der Erdungseinrichtung ausgebildet ist, über den eine Steuerinformation von der erweiterten Messeinrichtung an die Erdungseinrichtung zur Steuerung der Erdungseinrichtung übertragen wird.

Der Grundgedanke der vorliegenden Erfindung besteht somit darin, einspeiseseitig, in unmittelbarer Nähe der Stromquelle (Einspeisepunkt - im AC-System der Netztransformator) zwischen den aktiven Leitern und dem Schutzleiter, eine gesteuerte Erdungseinrichtung anzuordnen. Diese Erdungseinrichtung ist so ausgestaltet, dass sie entsprechend der über den Kommunikationskanal von der erweiterten Messeinrichtung empfangenen Steuerinformation wahlweise einen der aktiven Leiter gegen Erde einspeiseseitig aufschaltet und im Zusammenwirken mit der verbrauchsseitig angeordneten erweiterten Messeinrichtung eine Fehlerstromschleife bildet, deren Schleifenimpedanz gemessen werden kann. Eine manuelle Herstellung der Erdung vor Ort ist somit nicht erforderlich.

Die Steuerinformation wird dabei von der verbrauchsseitig, an einem Verbrauchspunkt, angeschlossenen erweiterten Messeinrichtung erzeugt und an die Erdungseinrichtung fernübertragen.

Damit steht eine automatisierte technische Lösung zur Messung der Schleifenimpedanz in ungeerdeten Stromversorgungssystemen zur Verfügung, die eine vorherige manuelle Erdung des IT-Netzes obsolet macht und zugleich auf einem zuverlässigen, normativ spezifizierten und damit anerkannten Messverfahren beruht.

In weiterer Ausgestaltung ist der Kommunikationskanal durch die Fehlerstromschleife gebildet, wobei in der Fehlerstromschleife ein modulierter Fehlerstrom fließt, der die Steuerinformation überträgt.

Als Kommunikationskanal zur unidirektionalen Übertragung der Steuerinformation wird in vorteilhafter Weise die installierte Infrastruktur in Form der aktiven Leiter und des Schutzleiters des ungeerdeten Stromversorgungssystems genutzt. Die durch die aktiven Leiter und den Schutzleiter gebildete und über die Erdungseinrichtung geschlossene Fehlerstromschleife dient als leitungsgebundener Übertragungsweg für die Steuerinformation, in dem als informationstragendes Signal ein modulierter Fehlerstrom fließt.

Bevorzugt weist der modulierte Fehlerstrom während einer Einstelldauer den Verlauf einer durch Amplitudenumtastung binär codierten Fehlerstrom-Impulsfolge auf, wobei in der Fehlerstrom-Impulsfolge als Steuerinformation codiert ist, welcher aktive Leiter zu erden ist.

Die an die Erdungseinrichtung zu sendende Steuerinformation, welcher der aktiven Leiter zu erden ist, wird durch Modulation (Amplitudenumtastung) des Fehlerstroms in Form einer binär codierten Fehlerstrom-Impulsfolge übertragen. Dabei ist der jeweiligen Schalterstellung in der Erdungseinrichtung ein vereinbartes, eindeutiges und möglichst unverwechselbares Fehlerstrom-Impulsmuster bestimmter Länge (Einstelldauer) zugeordnet, das in der erweiterten Messeinrichtung durch Ein-/Ausschalten des Fehlerstroms (Modulation durch Ein-/Aus-Umtastung - on-/off-keying) erzeugt und in der Erdungseinrichtung ausgewertet wird, um die einspeiseseitige Erdung des betreffenden aktiven Leiters zu schalten.

Durch die unverwechselbare Kommunikation mittels des Fehlerstrom-Impulsmusters wird nahezu ausgeschlossen, dass die Erdung durch konstante oder intermittierende Isolationsfehler fälschlicherweise angesteuert und ausgelöst wird.

In weiterer Ausgestaltung weist die erweiterte Messeinrichtung einen Ankoppel-Wahlschalter zum gesteuerten Aufschalten eines der aktiven Leiter, einen Lastwiderstand, über dem die Leiter-Erde-Spannung erfasst wird, einen Schließer zum gesteuerten Aufschalten des Lastwiderstands und eine Mess- und Steuerelektronik auf, wobei die Mess- und Steuerelektronik ausgelegt ist zur Messung der Leiter-Erde-Spannung, zur Steuerung des Ankoppel-Wahlschalters und des Schließers, zur Erzeugung und Übertragung der Steuerinformation über den Kommunikationskanal an die Erdungseinrichtung sowie zur Berechnung der Schleifenimpedanz.

Die erweiterte Messeinrichtung beruht auf einem Schleifenmessgerät mit grundsätzlich bekannter Messmethodik, weist darüber hinaus als besondere Erweiterung eine Mess- und Steuerelektronik auf, die zur erfindungsgemäßen automatischen Durchführung der Messaufgabe ausgelegt ist. Insbesondere steuert die Mess- und Steuerelektronik die Taktung des Schließers, um die Steuerinformation in Form der binär codierten Fehlerstrom-Impulsfolge an die zentral angeordnete, auf diese Weise fernsteuerbare, Erdungseinrichtung zu übertragen.

Mit Vorteil ist der Schließer als gesteuerter Halbleiterschalter ausgeführt.

Eine Ausführung des Schließers als Halbleiterschalter ermöglicht die Formung der Fehlerstrom-Impulsfolge mit einer Taktrate bis in den einstelligen kHz-Bereich.

Weiter weist die Erdungseinrichtung auf: Einen Drei-Wege-Schalter zur Erdung eines der aktiven Leiter und eine Mess- und Auswerteelektronik zur Auswertung des modulierten Fehlerstroms mit einem über Ankoppel-Kondensatoren zwischen die aktiven Leiter und den Schutzleiter angeschlossenen Messwiderstand. Die Ankoppel-Kondensatoren mit einer Kapazität im Bereich << $1\mu F$ ermöglichen somit in vorteilhafter Weise, dass ein - gemäß Norm dauerhaft anzuschließendes - Isolationsüberwachungsgerät (IMD) in seiner Messfunktion nicht beeinträchtigt wird, solange keine Schleifenimpedanz-Messung erfolgt.

Der Drei-Wege-Schalter schaltet das ungeerdete Stromversorgungssystem von dem im Normalbetrieb geschalteten ungeerdeten Zustand temporär in den geerdeten Zustand indem einer der aktiven Leiter mit der Schutzleitung verbunden wird. Welcher aktive Leiter zu erden ist, wird in der Mess- und Auswerteelektronik durch Auswerten der in der Fehlerstrom-Impulsfolge enthaltenen Steuerinformation festgelegt.

Die zuvor beschriebene erfindungsmäße Messanordnung setzt die in dem unabhängigen Verfahrensanspruch beschriebenen Verfahrensschritte um. Insoweit treffen auch die vorgenannten technischen Wirkungen und daraus entstehenden verfahrenstechnischen Vorteile auf die Verfahrensmerkmale zu.

Hervorzuheben sei insbesondere die Übertragung einer Steuerinformation von der erweiterten Messeinrichtung an eine Erdungseinrichtung zur (Fern-)Steuerung der Erdungseinrichtung mittels eines zwischen der erweiterten Messeinrichtung und der Erdungseinrichtung ausgebildeten unidirektionalen Kommunikationskanals.

Die erfindungsgemäße Messanordnung, bestehend aus der Erdungseinrichtung, der erweiterten Messeinrichtung und dem aus den aktiven Leitern und dem Schutzleiter gebildeten Kommunikationskanal vermeidet die bisher zur Schleifenimpedanzmessung notwendigen Eingriffe in die zentrale Elektroverteilung des ungeerdeten Stromnetzes. Diese automatisierte Messung der Schleifenimpedanz ist daher gegenüber einer Messung mit manuell durchzuführender Erdung technisch zuverlässiger und wirtschaftlich effizienter durchzuführen.

Mit Vorteil kann die Erdungseinrichtung Bestandteil eines Isolationsüberwachungsgerätes zur Bestimmung des Isolationswiderstands in einem ungeerdeten Stromversorgungssystem sein.

Ein - vorzugsweise normgemäßes - Isolationsüberwachungsgerät kann in Erweiterung seines Funktionsumfangs mit der beschriebenen Erdungseinrichtung ausgestattet sein, um in dem ungeerdeten Stromversorgungssystem neben der Isolationsüberwachung eine Messung der Schleifenimpedanz durchführen zu können.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:

Fig. 1    eine Messung der Schleifenimpedanz in einem ungeerdeten Stromversorgungssystem gemäß dem Stand der Technik,

Fig. 2    eine erfindungsgemäße Messanordnung mit Erdungseinrichtung, erweiterter Messeinrichtung und Kommunikationskanal und

Fig. 3    einen erfindungsgemäßen Verfahrensablauf mit Schalterstellungen.

Fig. 1 zeigt als Stand der Technik den prinzipiellen Messaufbau für eine Messung der Schleifenimpedanz $Z_s$ nach VDE 0100-600 (IEC 60364-6) mit einer Messeinrichtung 6 nach DIN EN 61557-3 (IEC 61557) in einem ungeerdeten Stromversorgungssystem 2.

Das ungeerdete Stromversorgungssystem 2 ist beispielhaft als AC-Netz mit einem Netztransformator an einem Einspeisepunkt 3 und zwei aktiven Leitern L1 und L2 ausgeführt, die jeweils eine Leitungsimpedanz mit einem Leitungswiderstand $R_{s,\ L1}$, $R_{s,\ L2}$ und einer Leitungsinduktivität $L_{s,\ L1}$, $L_{s,\ L2}$ aufweisen.

Ein Verbrauchspunkt 4 (Steckdose) weist neben der Verbindung mit den aktiven Leitern L1, L2 einen Anschluss des Schutzleiters PE auf, über den die leitfähigen Gehäuse der an das IT-Netz angeschlossenen Verbraucher geerdet sind.

Da bei dem ungeerdeten Stromversorgungssystem 2 per Definition alle aktiven Teile von dem Schutzleiter PE elektrisch getrennt sind, ist für eine Messung der Schleifenimpedanz $Z_s$ einspeiseseitig an der Stelle a oder b eine Brücke zu setzen, also eine Erdung eines der aktiven Leiter L1, L2 durchzuführen, wodurch das IT-Netz 2 an dem Einspeisepunkt 3 mit dem Schutzleiter PE verbunden wird. Erst nach Bildung dieser geschlossenen (Fehler-)Stromschleife W ist die Messung mit einer an den Verbrauchspunkt 4 angeschlossenen, herkömmlichen Messeinrichtung 6 nach dem Verfahren der Spannungsabsenkung mit Messung der Leiter-Erde-Spannung $U_0$ (im unbelasteten Fall) und $U_1$ (im belasteten Fall möglich.

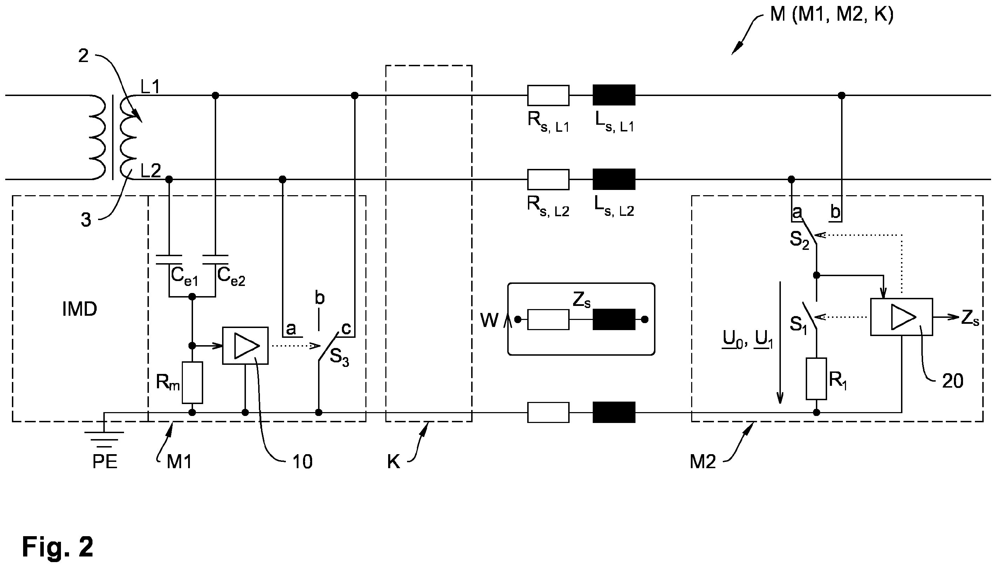

In Fig. 2 ist eine erfindungsgemäße Messanordnung M (M1, M2, K) für die Messung in dem ungeerdeten Stromversorgungssystem 2 dargestellt.

Die Messanordnung M umfasst als wesentliche Elemente eine Erdungseinrichtung M1, eine erweiterter Messeinrichtung M2 und einen Kommunikationskanal K.

Als Kommunikationskanal K zur Übertragung der Steuerinformation von der erweiterten Messeinrichtung M2 an die Erdungseinrichtung M1 dienen erfindungsgemäß die aktiven Leiter L1, L2 und der Schutzleiter PE.

Die Erdungseinrichtung M1 umfasst einen Drei-Wege-Schalter $S_3$ zur Erdung eines der aktiven Leiter L1, L2, eine Mess- und Auswertelektronik 10 zur Auswertung des modulierten Fehlerstroms und einen über Ankoppelkondensatoren $C_{e1}$, $C_{e2}$ zwischen die aktiven Leiter L1, L2 und den Schutzleiter angeschlossenen Messwiderstand $R_m$.

Der Drei-Wege-Schalter S3 steht im Normalbetrieb in Stellung b, sodass das ungeerdete Stromversorgungssystem 2 definitionsgemäß keine Erdung erfährt. Gesteuert von der Mess- und Auswertelektronik 10 kann der Drei-Wege-Schalter S3 wahlweise eine Erdung zwischen L1 und PE (Stellung c) oder L2 und PE (Stellung a) herstellen.

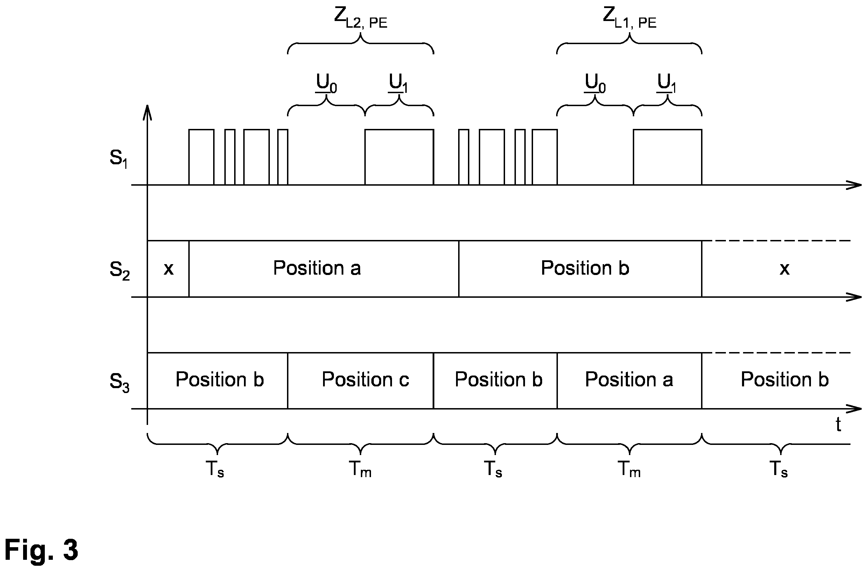

Die Mess- und Auswertelektronik 10 ist über Ankoppelkondensatoren $C_{e1}$, $C_{e2}$ mit kleinen Kapazitätswerten (Ce1, Ce2 << 1μF) und einen Messwiderstand $R_m$ an das ungeerdete IT-Netz 2 angebunden. Während einer Einstelldauer $T_s$ (Fig. 3) wird zunächst bei Stellung b des Drei-Wege-Schalters S3 die über dem Messwiderstand $R_m$ abfallende Spannung gemessen, um den modulierten Fehlerstrom, also die binär codierte Fehlerstrom-Impulsfolge, zu decodieren. Der Drei-Wege-Schalter S3 schaltet daraufhin den von der erweiterten Messeinrichtung M2 vorgegebenen aktiven Leiter L1 oder L2 gegen Erde und die eigentliche Schleifenimpedanzmessung kann ausgeführt werden.

Im Hinblick auf eine möglichst kompakte Realisierung der Messfunktionen für ein ungeerdetes Stromversorgungssystem 2 kann eine Integration der Erdungseinrichtung M1 in ein Isolationsüberwachungsgerät IMD vorgenommen werden.

Die erweiterte Messeinrichtung M2 umfasst einen Ankoppel-Wahlschalter $S_2$, einen Lastwiderstand $R_1$, einen Schließer $S_1$ und eine Mess- und Steuerelektronik 20 und kann als stationäre Einrichtung oder als mobiles, tragbares Gerät mit Steckeranschluss ausgeführt sein.

Mittels des Ankoppel-Wahlschalters $S_2$ mit den Stellungen a und b erfolgt ein gesteuertes Aufschalten eines der aktiven Leiter L1, L2. Damit wird durch die Mess- und Steuerelektronik 20 festgelegt, an welchem der aktiven Leiter L1, L2 die Schleifenimpedanz $Z_s$ gemessen werden soll.

Der Lastwiderstand $R_1$ wird mit dem Schließer S1 zugeschaltet. Der Schließer $S_1$ ist ferner in der Lage, bis in den einstelligen kHz-Bereich zu takten und damit den modulierten Fehlerstrom in Form der binär codierten Fehlerstrom-Impulsfolge zu erzeugen. Zu diesem Zweck ist der Schließer $S_1$ vorzugsweise als Halbleiterschalter ausgeführt.

Der Ankoppel-Wahlschalter $S_2$ und der Drei-Wege-Schalter $S_3$ können sowohl elektromechanisch als auch halbleiterbasiert ausgeführt sein.

Über dem Lastwiderstand $R_1$ wird die Leiter-Erde-Spannung $U_1$ im Belastungsfall - bei geschlossenem Schließer S1 - erfasst. Der Lastwiderstand $R_1$ ist so dimensioniert, dass beispielhaft bei einer Netz-Nennspannung von 230V ein Strom im einstelligen Ampere-Bereich in der Fehlerstromschleife W fließt.

Die Erfassung der Leiter-Erde-Spannung $U_0$ im unbelasteten Fall erfolgt über dem geöffneten Schließer S1 gegen Erde PE.

Die Messung der jeweiligen Leiter-Erde-Spannung $U_0$ (Leerlaufspannung im unbelasteten Fall - entspricht der Netz-Nennspannung) und $U_1$ (Netzspannung im resistiv belasteten Fall) sowie die Berechnungen zur Ermittlung der Schleifenimpedanz $Z_s$ werden in der Mess- und Steuerelektronik 20 durchgeführt.

Die Mess- und Steuerelektronik 20 dient darüber hinaus zur Steuerung des Ankoppel-Wahlschalters $S_2$ und mittels Steuerung des Schließers $S_1$ zur Erzeugung und Übertragung der Steuerinformation über den Kommunikationskanal K an die Erdungseinrichtung M1.

Fig. 3 zeigt einen erfindungsgemäßen Verfahrensablauf mit Schalterstellungen des Schließers $S_1$, des Ankoppel-Wahlschalters $S_2$ und des Drei-Wege-Schalters $S_3$. Es werden die Schalterstellungen und die Erfindungsidee verdeutlicht, wobei die der Schalterstellung des Schließers S1 entsprechende Modulation des Fehlerstroms aus grafischen Gründen stark vereinfacht dargestellt ist.

Prinzipiell lässt sich der Ablauf des erfindungsgemäßen Messverfahrens so beschreiben, dass die erweiterte Messeinrichtung M2 bei der Erdungseinrichtung M1 die Erdung eines der aktiven Leiter L1, L2 anfragt (Einstelldauer $T_s$), diese Erdung für eine kurze Zeitspanne (Messdauer $T_m$) hergestellt wird und innerhalb dieser Messdauer $T_m$ die Messung nach dem bekannten Verfahren der Spannungsabsenkung gemäß der oben angeführten Gleichung durchgeführt wird. Die Zeitspanne sollte einige Netzspannungsperioden umfassen, beläuft sich somit bei einem 50-Hz-Netz beispielsweise auf 10 Perioden, also 200ms. Bei geringerem Laststrom kann sich die Dauer auf eine einstellige Sekundenzahl ausdehnen, um das Signal-Rausch-Verhältnis zu verbessern.

Der Verfahrensablauf gestaltet sich im Detail derart, dass die erweiterte Messeinrichtung M2 mittels des Ankoppel-Wahlschalters $S_2$ auf die zu messende Fehlerstromschleife W - über den aktiven Leiter L2 (Stellung a) oder den aktiven Leiter L1 (Stellung b) - eingestellt wird und mittels des von der Mess- und Steuerelektronik 20 gesteuerten Schließers $S_1$ und den Lastwiderstand $R_1$ den Fehlerstrom während der Einstelldauer $T_s$ moduliert. Die Modulation erfolgt in Form einer binär codierten Fehlerstrom-Impulsfolge, die die Information enthält, an welchem der aktiven Leiter L1, L2 die Erdung hergestellt werden soll.

Die binär codierte Fehlerstrom-Impulsfolge weist eine hinreichend hohe Taktrate auf, sodass eine eindeutige und unterscheidbare Steuerinformation übermittelt werden kann und im Empfänger (Erdungseinrichtung M1) eine möglichst fehlerfreie Decodierung erfolgt.

Während der Übermittlung der Steuerinformation - in Stellung b des Drei-Wege-Schalter $S_3$ in der Erdungseinrichtung M1 - kommt die über die Ankoppelkondensatoren $C_{e1}$, $C_{e2}$ und den Messwiderstand $R_m$ geschlossene Stromschleife zum Tragen. Durch den in dieser Stromschleife fließenden Strom fällt an dem Messwiderstand $R_m$ im Takt der binär codierten Fehlerstrom-Impulsfolge eine Spannung ab, die von der Mess- und Auswertelektronik 10 erfasst wird. Hier wird die Information ausgewertet und der Drei-Wege-Schalter

$S_3$ entsprechend der Anfrage für die eigentliche Messung in Stellung a oder c geschaltet und damit die ideale Erdung der aktiven Leiter L2 oder L1 an dem Einspeisepunkt 3 hergestellt.

Nach Ablauf der Einstelldauer $T_s$ wird der Schließer $S_1$ geöffnet und es erfolgt die Messung der Leerlaufspannung $U_0$, danach wird der Schließer $S_1$ geschlossen und es erfolgt die Messung der Spannung unter Belastung $U_1$.

Nach erfolgter Messung geht der Drei-Wege-Schalter $S_3$ der Erdungseinrichtung M1 wieder selbstständig in Position b und der ungeerdete Zustand des Stromversorgungssystems 2 wird wiederhergestellt.

Das erfindungsgemäße Verfahren ist nicht auf die Anwendung in Verbindung mit dem hier dargestellten ungeerdeten Stromversorgungssystem 2 mit Wechselstromeinspeisung und zwei aktiven Leitern L2, L1 beschränkt. Die hier dargestellte Anwendung stellt ein Ausführungsbeispiel dar und das beanspruchte Verfahren sowie dessen Umsetzung in der Messanordnung sind prinzipiell auch in mehrphasigen AC-Netzen und DC-Netzen anwendbar. Allerdings ist bei der Installation in 3AC-Netzen ein 4-Wegeschalter in der Erdungseinrichtung M1 und ein 3-Wegeschalter in der erweiterten Messeinrichtung M2 erforderlich.

## Patentansprüche

1. Messanordnung (M (M1, M2, K)) zur Messung einer Schleifenimpedanz ($Z_s$) einer aus einem aktiven Leiter (L1, L2) und einem Schutzleiter (PE) gebildeten Fehlerstromschleife (W) in einem ungeerdeten Stromversorgungssystem (2), mit einer an einem Verbrauchspunkt (4) angeschlossenen Messeinrichtung (6) zur Messung einer Leiter-Erde-Spannung ($U_0$, $U_1$) und zur Berechnung der Schleifenimpedanz ($Z_s$),
**dadurch gekennzeichnet,**
**dass** an einem Einspeisepunkt (3) des ungeerdeten Stromversorgungssystems (2) zwischen den aktiven Leitern (L1, L2) und dem Schutzleiter (PE) eine gesteuerte Erdungseinrichtung (M1) angeordnet ist, welche die Erdung eines der aktiven Leiter (L1, L2) schaltet, und dass ein unidirektionaler Kommunikationskanal (K) zwischen einer erweiterten Messeinrichtung (M2) und der Erdungseinrichtung (M1) ausgebildet ist, über den eine Steuerinformation von der erweiterten Messeinrichtung (M2) an die Erdungseinrichtung (M1) zur Steuerung der Erdungseinrichtung (M1) übertragen wird.

2. Messanordnung (M) nach Anspruch 1,
**dadurch gekennzeichnet,**
**dass** der Kommunikationskanal (K) durch die Fehlerstromschleife (W) gebildet ist, wobei in der Fehlerstromschleife (W) ein modulierter Fehlerstrom fließt, der die Steuerinformation überträgt.

3. Messanordnung (M) nach Anspruch 2,
**dadurch gekennzeichnet,**
**dass** der modulierte Fehlerstrom während einer Einstelldauer ($T_s$) den Verlauf einer durch Amplitudenumtastung binär codierten Fehlerstrom-Impulsfolge aufweist, wobei in der Fehlerstrom-Impulsfolge als Steuerinformation codiert ist, welcher aktive Leiter zu erden ist.

4. Messanordnung (M) nach einem der Ansprüche 1 bis 3,
**dadurch gekennzeichnet,**
**dass** die erweiterte Messeinrichtung (M2) einen Ankoppel-Wahlschalter ($S_2$) zum gesteuerten Aufschalten eines der aktiven Leiter (L1, L2), einen Lastwiderstand ($R_1$), über dem die Leiter-Erde-Spannung ($U_0$, $U_1$) erfasst wird, einen Schließer (S1) zum gesteuerten Aufschalten des Lastwiderstands ($R_1$) und eine Mess- und Steuerelektronik (20) aufweist, wobei die Mess- und Steuerelektronik (20) ausgelegt ist zur Messung der Leiter-Erde-Spannung ($U_0$, $U_1$), zur Steuerung des Ankoppel-Wahlschalters ($S_2$) und des Schließers ($S_1$), zur Erzeugung und Übertragung der Steuerinformation über den Kommunikationskanal (K) an die Erdungseinrichtung (M1) sowie zur Berechnung der Schleifenimpedanz ($Z_s$).

5. Messanordnung (M) nach Anspruch 4,
**dadurch gekennzeichnet,**
**dass** der Schließer (S1) als Halbleiterschalter ausgeführt ist.

6. Messanordnung (M) nach einem der Ansprüche 1 bis 5,
**dadurch gekennzeichnet,**
**dass** die Erdungseinrichtung (M1) einen Drei-Wege-Schalter ($S_3$) zur Erdung eines der aktiven Leiter und eine Mess- und Auswertelektronik (10) zur Auswertung des modulierten Fehlerstroms mit einem über Ankoppelkondensatoren ($C_{e1}$, $C_{e2}$) zwischen die aktiven Leiter (L1, L2) und den Schutzleiter (PE) angeschlossenen Messwiderstand ($R_m$) aufweist.

7. Isolationsüberwachungsgerät (IMD) zur Bestimmung des Isolationswiderstands in einem ungeerdeten Stromversorgungssystem (2) **gekennzeichnet durch**
eine Erdungseinrichtung (M1) nach einem der Ansprüche 1 bis 6.

8. Messverfahren zur Messung einer Schleifenimpedanz ($Z_s$) einer aus einem aktiven Leiter (L1, L2) und einem Schutzleiter gebildeten Fehlerstromschleife (W) in einem ungeerdeten Stromversorgungssystem (2), umfassend die Verfahrensschritte:

Messen einer Leiter-Erde-Spannung ($U_0$, $U_1$)

und Berechnen der Schleifenimpedanz ($Z_s$) mittels einer an einem Verbrauchspunkt (4) angeschlossenen erweiterten Messeinrichtung (M2), **dadurch gekennzeichnet,** **dass** die Erdung eines der aktiven Leiter (L1, L2) mittels einer an einem Einspeisepunkt (3) des ungeerdeten Stromversorgungssystems zwischen den aktiven Leitern und dem Schutzleiter angeordneten gesteuerten Erdungseinrichtung (M1) geschaltet wird, und **dass** eine Steuerinformation von der erweiterten Messeinrichtung (M2) an die Erdungseinrichtung (M1) zur Steuerung der Erdungseinrichtung (M1) mittels eines zwischen der erweiterten Messeinrichtung (M2) und der Erdungseinrichtung (M1) ausgebildeten unidirektionalen Kommunikationskanals (K) übertragen wird.

9. Messverfahren nach Anspruch 8,
   **dadurch gekennzeichnet,**
   **dass** die Steuerinformation durch einen modulierten Fehlerstrom übertragen wird, der in der den Kommunikationskanal (K) bildenden Fehlerstromschleife (W) fließt.

10. Messverfahren nach Anspruch 9,
    **dadurch gekennzeichnet,**
    **dass** der modulierte Fehlerstrom während einer Einstelldauer $T_s$ als binär codierte Fehlerstrom-Impulsfolge übertragen wird, wobei in der Fehlerstrom-Impulsfolge als Steuerinformation codiert ist, welcher aktive Leiter (L1, L2) zu erden ist.

11. Messverfahren nach einem der Ansprüche 8 bis 10,
    **gekennzeichnet durch**,
    gesteuertes Aufschalten eines der aktiven Leiter (L1, L2) mittels eines Ankoppel-Wahlschalters ($S_2$) der erweiterten Messeinrichtung (M2),
    Erfassen der Leiter-Erde-Spannung ($U_0$, $U_1$) über einem Lastwiderstand ($R_1$) in der erweiterten Messeinrichtung (M2),
    gesteuertes Aufschalten des Lastwiderstands ($R_1$) mittels eines Schließers (S1) der erweiterten Messeinrichtung (M2),
    Messen der Leiter-Erde-Spannung ($U_0$, $U_1$) mittels einer Mess- und Steuerelektronik (20) der erweiterten Messeinrichtung (M2), Steuern des Ankoppel-Wahlschalters ($S_2$) und des Schließers (S1), Erzeugen und Übertragen der Steuerinformation mittels der Mess- und Steuerelektronik (20) und
    Berechnen der Schleifenimpedanz ($Z_s$) mittels der Mess- und Steuerelektronik (20).

12. Messverfahren nach Anspruch 11,
    **dadurch gekennzeichnet,**
    **dass** das Aufschalten des Lastwiderstands (R1) mittels eines als Halbleiterschalter ausgeführten Schließers ($S_1$) erfolgt.

13. Messverfahren nach einem der Ansprüche 8 bis 12,
    **dadurch gekennzeichnet** durch

    Erden eines der aktiven Leiter (L1, L2) mittels eines Drei-Wege-Schalters (S3) der Erdungseinrichtung (M1),
    Auswerten des modulierten Fehlerstroms mittels einer Mess- und Auswertelektronik (10) mit einem über Ankoppelkondensatoren ($C_{e1}$, $C_{e2}$) angeschlossenen Messwiderstand ($R_m$).

**Claims**

1. A measuring arrangement (M (M1, M2, K)) for measuring a loop impedance ($Z_s$) of a residual current loop (W) formed by an active conductor (L1, L2) and a protective conductor (PE) in an ungrounded power supply system (2), the measuring arrangement (M (M1, M2, K)) having a measuring device (6) connected to a consumer point (4) and serving to measure a conductor-to-ground voltage ($U_0$, $U_1$) and to compute the loop impedance ($Z_s$),
   **characterized in that**
   a controlled grounding device (M1) is disposed between the active conductors (L1, L2) and the protective ground (PE) at a feeding point (3) of the ungrounded power supply system (2) and switches the grounding of one of the active conductors (L1, L2), and **in that** a unidirectional communication channel (K) is formed between an extended measuring device (M2) and the grounding device (M1), control information being transmitted from the extended measuring device (M2) to the grounding device (M1) via the communication channel (K) in order to control the grounding device (M1).

2. The measuring arrangement (M) according to claim 1,
   **characterized in that**
   the communication channel (K) is formed by the residual current loop (W), a modulated residual current, which transmits the control information, flowing in the residual current loop (W).

3. The measuring arrangement (M) according to claim 2,
   **characterized in that**
   during a setting time ($T_s$), the modulated residual current has the shape of a residual-current pulse sequence binary encoded via amplitude modulation, the active conductor to be grounded being encoded in the residual-current pulse sequence as the control information.

4. The measuring arrangement (M) according to any one of the claims 1 to 3,
**characterized in that**
the extended measuring device (M2) has a coupling change-over switch (S2) for the controlled overriding of one of the active conductors (L1, L2), a load resistance ($R_1$), via which the conductor-to-ground voltage ($U_0$, $U_1$) is registered, a make contact (S1) for the controlled overriding of the load resistance ($R_1$) and measuring and control electronics (20), the measuring and control electronics (20) being configured to measure the conductor-to-ground voltage ($U_0$, $U_1$), to control the coupling change-over switch (S2) and the make contact (S1), to generate and transmit the control information to the grounding device (M1) via the communication channel (K) and to compute the loop impedance ($Z_s$).

5. The measuring arrangement (M) according to claim 4,
**characterized in that**
the make contact (S1) is designed as a semiconductor switch.

6. The measuring arrangement (M) according to any one of the claims 1 to 5,
**characterized in that**
the grounding device (M1) has a three-way switch (S3) for grounding one of the active conductors and measuring and evaluation electronics (10) for evaluating the modulated residual current using a measuring resistance ($R_m$) connected between the active conductors (L1, L2) and the protective conductor (PE) via coupling capacitors ($C_{e1}$, $C_{e2}$).

7. An insulation monitoring device (IMD) for determining the insulation resistance in an ungrounded power supply system (2)
**characterized by**
a grounding device (M1) according to any one of the claims 1 to 6.

8. A measuring method for measuring a loop impedance ($Z_s$) of a residual current loop (W) formed by an active conductor (L1, L2) and a protective conductor in an ungrounded power supply system (2), the method comprising the following steps:

measuring a conductor-to-ground voltage ($U_0$, $U_1$) and computing the loop impedance ($Z_s$) by means of an extended measuring device (M2) connected to a consumer point (4),
**characterized in that**
the grounding of one of the active conductors (L1, L2) is switched by means of a controlled grounding device (M1) disposed at a feeding point (3) of the ungrounded power supply system between the active conductors and the protective conductor, and
**in that** control information is transmitted to the grounding device (M1) from the extended measuring device (M2) by means of a unidirectional communication channel (K) formed between the extended measuring device (M2) and the grounding device (M1) in order to control the grounding device (M1).

9. The measuring method according to claim 8,
**characterized in that**
the control information is transmitted by a modulated residual current which flows in the residual current loop (W) forming the communication channel (K).

10. The measuring method according to claim 9,
**characterized in that**
the modulated residual current is transmitted as a binary-encoded residual-current pulse sequence during a setting time ($T_s$), the active conductor (L1, L2) to be grounded being encoded in the residual-current pulse sequence as control information.

11. The measuring method according to any one of the claims 8 to 10, **characterized by**

a controlled overriding of one of the active conductors (L1, L2) by means of a coupling change-over switch ($S_2$) of the extended measuring device (M2),
a detection of the conductor-to-ground voltage ($U_0$, $U_1$) via a load resistance ($R_1$) in the extended measuring device (M2),
a controlled overriding of the load resistance ($R_1$) by means of a make contact ($S_1$) of the extended measuring device (M2),
a measurement of the conductor-to-ground voltage ($U_0$, $U_1$) by means of measuring and control electronics (20) of the extended measuring device (M2),
a control of the coupling change-over switch ($S_2$) and the make contact (S1),
a generation and transmission of the control information by means of the measuring and control electronics (20), and
a computation of the loop impedance ($Z_s$) by means of the measuring and control electronics (20).

12. The measuring method according to claim 11,
**characterized in that**
the load resistance ($R_1$) is overridden by means of a make contact (S1) designed as a semiconductor switch.

13. The measuring method according to any one of the claims 8 to 12,
**characterized by**

a grounding of one of the active conductors (L1, L2) by means of a three-way switch (S3) of the grounding device (M1),

an evaluation of the modulated residual current by means of measuring and evaluation electronics (10) using a measuring resistance ($R_m$) connected via coupling capacitors ($C_{e1}$, $C_{e2}$).

**Revendications**

1. Agencement de mesure (M (M1, M2, K)) pour mesurer une impédance ($Z_s$) d'une boucle de courant résiduel (W) formée par un conducteur actif (L1, L2) et un conducteur de protection (PE) dans un système (2) d'alimentation en courant non mis à la terre, l'agencement de mesure (M (M1, M2, K)) ayant un dispositif de mesure (6) relié à un point de consommateur (4) et servant à mesurer une tension ($U_0$, $U_1$) entre le conducteur et la terre et à calculer l'impédance de boucle ($Z_s$),
**caractérisé en ce**
**qu'**un dispositif de mise à la terre (M1) commandé est disposé entre les conducteurs actifs (L1, L2) et la terre de protection (PE) à un point d'alimentation (3) du système (2) d'alimentation en courant non mis à la terre et commute la mise à la terre de l'un des conducteurs actifs (L1, L2), et **en ce qu'**un canal de communication (K) unidirectionnel est formé entre un dispositif de mesure étendu (M2) et le dispositif de mise à la terre (M1), une information de contrôle étant transmise du dispositif de mesure étendu (M2) au dispositif de mise à la terre (M1) par l'intermédiaire du canal de communication (K) afin de commander le dispositif de mise à la terre (M1).

2. Agencement de mesure (M) selon la revendication 1,
**caractérisé en ce que**
le canal de communication (K) est formé par la boucle du courant résiduel (W), un courant résiduel modulé, qui transmet l'information de contrôle, circulant dans la boucle du courant résiduel (W).

3. Agencement de mesure (M) selon la revendication 2,
**caractérisé en ce que**
pendant un temps de réglage ($T_s$), le courant résiduel modulé a la courbe d'un train d'impulsions du courant résiduel encodé en binaire par l'intermédiaire d'une modulation d'amplitude, le conducteur actif à mettre à la terre étant codé dans le train d'impulsions du courant résiduel en tant qu'information de contrôle.

4. Agencement de mesure (M) selon l'une quelconque des revendications 1 à 3,
**caractérisé en ce que**
le dispositif de mesure étendu (M2) a un commutateur de couplage (S2) pour la mise en ligne contrôlée de l'un des conducteurs actifs (L1, L2), une résistance de charge ($R_1$), par l'intermédiaire de laquelle la tension ($U_0$, $U_1$) entre le conducteur et la terre est enregistrée, un contact de travail (S1) pour la mise en ligne contrôlée de la résistance de charge ($R_1$) et une électronique de mesure et de commande (20), l'électronique de mesure et de commande (20) étant configurée pour mesurer la tension ($U_0$, $U_1$) entre le conducteur et la terre, pour commander le commutateur de couplage (S2) et le contact de travail (S1), pour générer et transmettre l'information de contrôle au dispositif de mise à la terre (M1) par l'intermédiaire du canal de communication (K) et pour calculer l'impédance de boucle ($Z_s$).

5. Agencement de mesure (M) selon la revendication 4,
**caractérisé en ce que**
le contact de travail (S1) est conçu comme un interrupteur à semi-conducteurs.

6. Dispositif de mesure (M) selon l'une quelconque des revendications 1 à 5,
**caractérisé en ce que**
le dispositif de mise à la terre (M1) a un commutateur (S3) à trois appareils de coupure pour mettre à la terre l'un des conducteurs actifs et une électronique de mesure et d'évaluation (10) pour évaluer le courant résiduel modulé au moyen d'une résistance de mesure ($R_m$) reliée entre les conducteurs actifs (L1, L2) et le conducteur de protection (PE) par l'intermédiaire de condensateurs de couplage ($C_{e1}$, $C_{e2}$).

7. Dispositif de surveillance d'isolement (IMD) pour déterminer la résistance d'isolement dans un système (2) d'alimentation en courant non mis à la terre
**caractérisé par**
un dispositif de mise à la terre (M1) selon l'une quelconque des revendications 1 à 6.

8. Procédé de mesure pour mesurer une impédance ($Z_s$) d'une boucle de courant résiduel (W) formée par un conducteur actif (L1, L2) et un conducteur de protection dans un système (2) d'alimentation en courant non mis à la terre, le procédé comprenant les étapes suivantes :

la mesure d'une tension ($U_0$, $U_1$) entre le conducteur et la terre et le calcul de l'impédance de boucle ($Z_s$) au moyen d'un dispositif de mesure étendu (M2) relié à un point de consommateur (4),
**caractérisé en ce que**
la mise à la terre de l'un des conducteurs actifs (L1, L2) est commutée au moyen d'un dispositif de mise à la terre commandé (M1) disposé à un point d'alimentation (3) du système d'alimentation non mis à la terre entre les conducteurs actifs et le conducteur de protection, et

**en ce que** l'information de contrôle est transmise au dispositif de mise à la terre (M1) à partir du dispositif de mesure étendu (M2) au moyen d'un canal de communication (K) unidirectionnel formé entre le dispositif de mesure étendu (M2) et le dispositif de mise à la terre (M1) afin de contrôler le dispositif de mise à la terre (M1).

9. Procédé de mesure selon la revendication 8, **caractérisé en ce que**
l'information de contrôle est transmise par un courant résiduel modulé qui circule dans la boucle du courant résiduel (W) formant le canal de communication (K).

10. Procédé de mesure selon la revendication 9, **caractérisé en ce que**
le courant résiduel modulé est transmis sous la forme d'un train d'impulsions du courant résiduel encodé en binaire pendant un temps de réglage ($T_s$), le conducteur actif (L1, L2) à mettre à la terre étant codé dans le train d'impulsions du courant résiduel en tant qu'information de contrôle.

11. Procédé de mesure selon l'une quelconque des revendications 8 à 10, **caractérisé par**

la mise en ligne contrôlée de l'un des conducteurs actifs (L1, L2) au moyen d'un commutateur de couplage ($S_2$) du dispositif de mesure étendu (M2),
la détection de la tension ($U_0$, $U_1$) entre le conducteur et la terre par l'intermédiaire d'une résistance de charge ($R_1$) dans le dispositif de mesure étendu (M2),
la mise en ligne contrôlée de la résistance de charge ($R_1$) au moyen d'un contact de travail ($S_1$) du dispositif de mesure étendu (M2),
la mesure de la tension ($U_0$, $U_1$) entre le conducteur et la terre au moyen de l'électronique de mesure et de commande (20) du dispositif de mesure étendu (M2),
le contrôle du commutateur de couplage ($S_2$) et du contact de travail (S1),
la génération et la transmission de l'information de contrôle au moyen de l'électronique de mesure et de commande (20), et
le calcul de l'impédance de boucle ($Z_s$) au moyen de l'électronique de mesure et de commande (20).

12. Procédé de mesure selon la revendication 11, **caractérisé en ce que**
la résistance de charge ($R_1$) est mise en ligne au moyen d'un contact de travail (S1) conçu comme interrupteur à semi-conducteurs.

13. Procédé de mesure selon l'une quelconque des revendications 8 à 12, **caractérisé par**

la mise à la terre de l'un des conducteurs actifs (L1, L2) au moyen d'un commutateur à trois appareils de coupure (S3) du dispositif de mise à la terre (M1),
l'évaluation du courant résiduel modulé au moyen d'une électronique de mesure et d'évaluation (10) au moyen d'une résistance de mesure ($R_m$) reliée par l'intermédiaire d'un condensateur de couplage ($C_{e1}$, $C_{e2}$).

Fig. 1
Stand der Technik

**Fig. 2**

EP 4 575 525 B1

Fig. 3

EP 4 575 525 B1

EP 4 575 525 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0915347 A